# EUROPEAN PATENT APPLICATION

(11) **EP 3 306 764 A1**
(43) Date of publication of application: **11.04.2018**
(21) Application number: 16192523.5
(22) Date of filing: 06.10.2016
(51) Int. Cl.: H02H 1/00, G08B 17/12, H02B 13/065, G01R 31/12

(54) **SENSOR ARRANGEMENT FOR OPTICAL ARC FLASH DETECTION**

(71) Applicant: ABB Schweiz AG, 5400 Baden (CH)
(72) Inventor: Keisala, Oskari, 65320 Vaasa (FI); Saari, Paavo, 65320 Vaasa (FI)
(74) Representative: Kolster Oy Ab

(57) **Abstract**

A sensor arrangement for an optical arc flash detection system, the arrangement comprising a body part (10), a connector part (20) releasably connected to the body part and adapted to connect to at least two optical fibres, a lens part (30) releasably connected to the body part (10) and adapted to transmit light from outside of the sensor arrangement towards the connector part (20), and a prism part (40) located between the lens part (30) and the connector part (20) and adapted to transmit light from the lens part towards the connector part (20) and to reflect light from one optical fibre connected to the connector part (20) to another optical fibre connected to the connector part (20).

## Description

### FIELD OF THE INVENTION

The present invention relates to a sensor arrangement for an optical arc flash detection system.

### BACKGROUND OF THE INVENTION

An optical arc protection system may be used to protect electric equipment and surroundings thereof from potential damage caused by an electric arc. The optical arc protection system may detect an arc and give a trip command to one or more circuit breakers that may feed an arc fault in an electric system. The optical arc protection system can optically sense arc flashes via one or more sensors connected to the system. An interruption of an arc with an optical arc protection system can reduce arc energy significantly, thus reducing the risk of personal injury and property damage, for example.

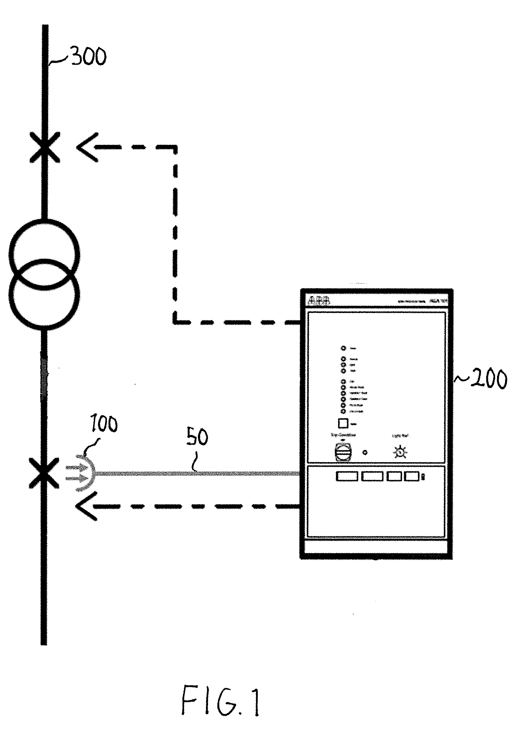

A sensor for such an optical arc protection system may be implemented by a light collecting sensor device which is connected to a control unit of the optical arc protection system, such as a protective relay unit, or a corresponding entity, via an optical fibre connection comprising at least one optical fibre. Thus, the light collected by the sensor device can be transmitted from the sensor device to the control unit of the optical arc protection system via the optical fibre of the optical fibre connection. Figure 1 shows an example of an optical arc protection system comprising a control unit 200 and one sensor 100 connected to the control unit via an optical fibre connection 50. In the example, the sensor 100 is located in proximity to a component or portion, for example, of an electric system 300, such as an electric network or part thereof, to be monitored. Upon detecting an arc with the sensor 100, the control unit 200 may operate switches or circuit breakers of the electric system 300, for example, and/or send an alarm to an operator of the system, for example.

This kind of optical arc protection system utilizing such remote light collecting sensor devices 100 may include a self-supervision functionality for monitoring the functioning of the remote light collecting sensor 100 and the optical fibre connection 50 connecting the remote light collecting sensor to the control unit of the optical arc protection system. Such monitoring may be implemented by providing in the optical fibre connection 50 at least one additional optical fibre between the remote light collecting sensor and the control unit of the optical arc protection system which additional fibre can be used for sending, e.g. periodically, test light pulses from the control unit of the optical arc protection system to the remote light collecting sensor. These test light pulses may then be reflected back to the control unit of the optical arc protection system from the remote light collecting sensor via the primary optical fibre between the remote light collecting sensor and the optical arc protection system, which is normally used to convey the light from the sensor 100 to the control unit 200. Then, unless such a sent test pulse is received back to the control unit 200 of the optical arc protection system, it may be determined that there is a break in the optical fibre connection 50, in either the primary or the additional optical fibre, or in both of them, between the remote light collecting sensor 100 and the control unit 200 of the optical arc protection system, and appropriate measures may be taken in order to remedy the situation.

The reflection of the test light pulses from one optical fibre to another in the remote light collecting sensor 100 may be achieved with one or more polished surfaces within the sensor. A problem associated with such an arrangement utilizing one or more polished surfaces in the sensor is that the resulting reflection may not be strong, which limits the maximum fibre length. In addition, a polished surface inside the sensor may greatly affect the acceptance cone of the sensor, i.e. the sensor's ability to collect light from different directions.

### BRIEF DESCRIPTION OF THE INVENTION

An object of the present invention is thus to provide an apparatus so as to overcome the above problems, or at least to alleviate them. The object of the invention is achieved by a sensor arrangement for an optical arc flash detection system and an optical arc flash detection system which are characterized by what is stated in the independent claims. Preferred embodiments of the invention are disclosed in the dependent claims.

The invention is based on the idea of using an optical prism element in the light collecting sensor, which prism element is adapted to pass light coming from outside of the sensor towards the optical fibres connected to the sensor and to reflect light from one optical fibre connected to the sensor to another optical fibre connected to the sensor.

An advantage of the arrangement of the invention is that a strong and reliable reflection can be obtained with the optical prism element. In addition, the acceptance cone of the sensor is less affected by the prism element.

### BRIEF DESCRIPTION OF THE DRAWINGS

In the following, the invention will be described in greater detail by means of preferred embodiments with reference to the accompanying drawings, in which
Figure 1 is an example of an optical arc protection system according to an embodiment;
Figure 2 is an example of a light collecting sensor according to an embodiment;
Figure 3 is an example of a light collecting sensor according to an embodiment;
Figure 4 is an example of a light collecting sensor according to an embodiment;
Figure 5 is an example of light reflection in a prism element according to an embodiment; and
Figure 6 is an example of light reflection in a prism element according to an embodiment.

### DETAILED DESCRIPTION OF THE INVENTION

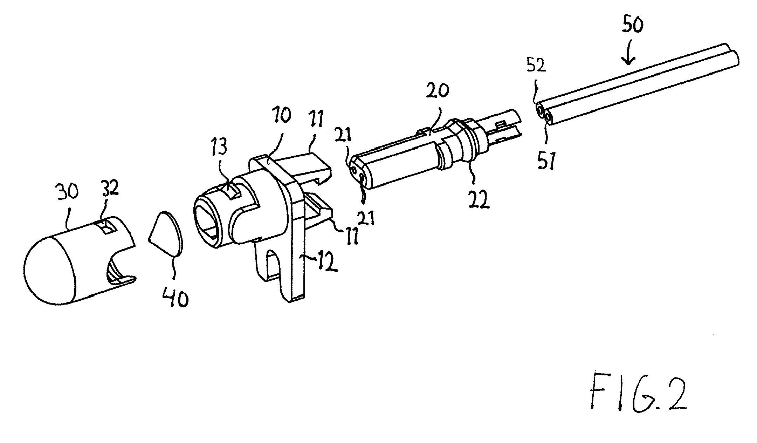

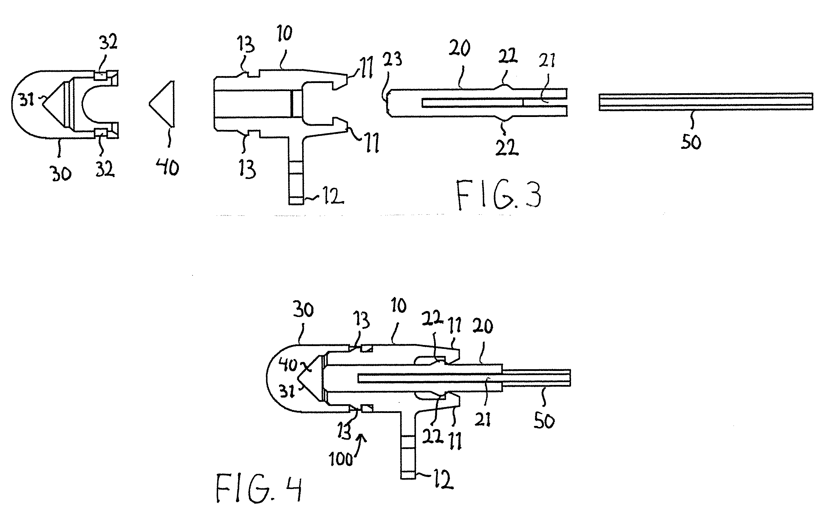

Figures 2, 3 and 4 show an example of a light collecting sensor arrangement 100 according to an embodiment such that Figure 2 shows an exploded view of the sensor arrangement 100, Figure 3 shows an exploded sectional view of the sensor arrangement 100 and Figure 4 an assembled sectional view of the sensor arrangement 100. According to an embodiment, the sensor arrangement 100 for an optical arc flash detection system comprises a body part 10, a connector part 20 releasably connected to the body part 10 and adapted to connect to at least two optical fibres 51, 52, and a lens part 30 releasably connected to the body part 10 and adapted to transmit light from outside of the sensor arrangement towards the connector part 20. The releasable connection between the connector part 20 and the body part 10 may be realized by using suitable releasable connection means, such as the illustrated fastening claws 11 of the body part 10 engaging the fastening protrusions 22 of the connector part 20 in a releasable manner. In a similar manner, the releasable connection between the lens part 30 and the body part 10 may be realized by using suitable releasable connection means, such as the illustrated fastening claws 13 of the body part 10 engaging the apertures 32 of the lens part 30 in a releasable manner. The body part 10 may further comprise suitable fastening means, such as the illustrated fastening lug 12, for fastening the body part 10, and hence the whole sensor arrangement 100, to a structure on the site of the intended use of the sensor arrangement 100, for example. Moreover, the sensor arrangement 100 for an optical arc flash detection system comprises a prism part 40 located between the lens part 30 and the connector part 20 and adapted to transmit light from the lens part 30 towards the connector part 20 and to reflect light from one optical fibre 51, 52 connected to the connector part 20 to another optical fibre 51, 52 connected to the connector part 20. The optical fibres 51, 52 for the optical fibre connection 50 could be separate optical fibres or part of a multi-fibre optical cable, such as a duplex optical cable as illustrated in the exemplary figures, or a multicore optical cable, for example. According to an embodiment, the sensor arrangement 100 comprises at least two optical fibres 51, 52 connected to the connector part 20. According to an embodiment, the sensor arrangement 100 comprises an optical fibre cable comprising said at least two optical fibres 51, 52 connected to the connector part 20. According to an embodiment, the prism part 40 and the connector part 20 are adjacent to each other, i.e. either in contact with each other or at least in close proximity to each other as illustrated in Figure 4.

According to an embodiment, the connector part 20 may have at least two parallel slots 21 for receiving the at least two optical fibres 51, 52, wherein the ends of the slots facing the prism part 40 are open. The optical fibres 51, 52 may be connected to the connector part 20 by pushing the ends of the optical fibres 51, 52 into the slots 21, or the connector part 20 may be configured to be split or opened to better enable the inserting of the ends of the optical fibres 51, 52 into the slots 21, for example. According to an embodiment, the connector part 20 is adapted to receive the optical fibres 51, 52 such that the ends of the optical fibres 51, 52 come essentially flush with the end 23 of the connector part 20 entering the body part 10 in order to bring the ends of the optical fibres 51, 52 in contact with or at least in close proximity to the prism part 40. The connection of the optical fibres 51, 52 to the connector part 20 may be accomplished by clamping, crimping and/or with adhesive bonding, for example. Depending on the structure of the optical fibres 51, 52, it may be necessary to peel away a possible jacket around them in order to fit them into the slots 21. According to an embodiment, the at least two parallel slots 21 are adjacent to each other. The exact preferable position of the slots 21 in relation to each other depends on the structure of the optical fibres 51, 52 and the characteristics of the prism part 40, for example, and may thus vary. According to an embodiment, the slots 21 are positioned such that the ends of the optical fibres 51, 52 received therein come close to each other and close to the centre of the prism part 40 facing them.

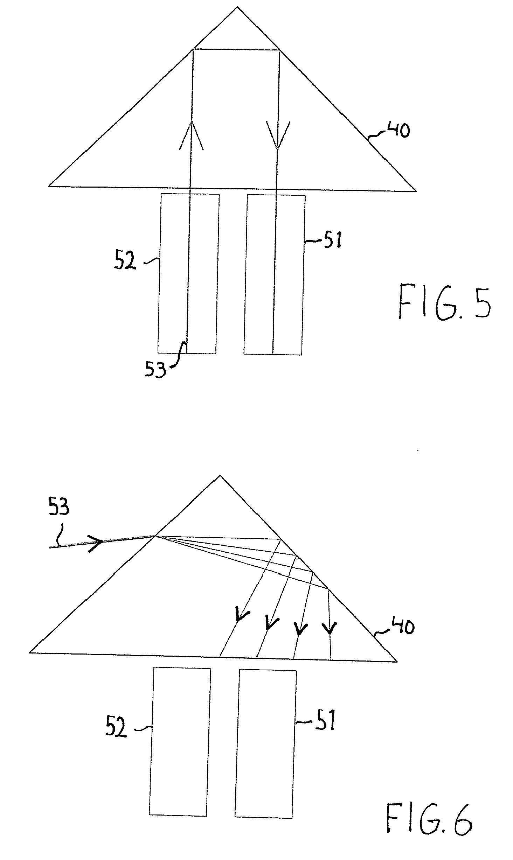

According to an embodiment, the prism part 40 preferably comprises a reflection prism. According to an embodiment, the reflection prism is of transparent material or at least translucent material. According to an embodiment, the reflection prism 40 has a cone shape such that the apex of the cone faces the lens part 30 and the base of the cone faces the connector part 20. Thus, the ends of the optical fibres 51, 52 connected to the connector part 20 will face the base of the cone-shaped prism part 40. The cone may be a circular cone, as illustrated, or another kind of cone, such as an elliptic cone or a pyramid having a polygonal base. Moreover, the base of such a pyramid may be a triangle, a square, a pentagon or generally a polygon, such as a convex or concave polygon, with three or more vertices. Generally, the cone may be a right cone or an oblique cone. According to an embodiment, the apex angle of the cone is preferably 90° but may vary depending on the material of the cone, for example. Generally, the prism part 40 may be designed and dimensioned such that a total internal reflection (TIR) can be achieved for light being reflected from one of the optical fibres 51, 52 to another by the prism part 40. Figure 5 illustrates an example of a cone-shaped prism part 40 having an apex angle of 90°. In addition, Figure 5 illustrates the ends of two optical fibres 51, 52 adjacent to the base of the cone-shaped prism part 40 and close to the centre of the base of the prism part 40. For the sake of clarity, Figure 5 does not show other parts of the sensor arrangement 100. The figure shows how light 53 coming from one of the optical fibres, in this example 52, is essentially completely reflected by the prism part 40 to the other optical fibre 51 by undergoing total internal reflection twice from the sides of the cone-shaped prism part 40. Figure 6 illustrates how light 53 entering the cone-shaped prism part 40 through one of its sides is reflected towards the ends of two optical fibres 51, 52 residing in the connector part 20 (not shown in Figure 6 for the sake of clarity). Thus, such a prism part 40 as illustrated in Figures 5 and 6 is able to transmit light from the lens part 30 towards the connector part 20 and to reflect light from one optical fibre 51, 52 connected to the connector part 20 to another optical fibre 51, 52 connected to the connector part 20.

According to an embodiment, the lens part 30 comprises at least one transparent or at least translucent portion allowing light to be transmitted from outside of the sensor arrangement towards the connector part 10. It is thus possible that the whole lens part 30 is transparent or at least translucent or that only a portion or portions thereof are transparent or at least translucent. According to an embodiment, the lens part 30 may comprise a recess 31 for receiving the prism part 40 such that at least one side of the prism part is adjacent to the at least one transparent or at least translucent portion. For example, in the examples of Figures 3 and 4, the whole lens part 30 may be transparent or at least translucent, whereby, when the prism part 40 is received to the recess 31 of the lens part 30, the side of the cone-shaped prism part 40 is adjacent to the transparent or at least translucent portion. Light coming from outside of the sensor arrangement 100 will then be transmitted towards the connector part 20 through the prism part 40.

It should be noted that the shape of the various parts of the sensor arrangement 100 described above may vary. For example, the shape of the lens part 30 and the prism part 40 may be designed according to the requirements and system characteristics of the electric system to be monitored with the sensor arrangement 100. For example, the sensitivity of the sensor arrangement 100 and/or its ability to collect light from various angles may be adjusted by adjusting the shape of the lens part 30 and/or the prism part 40. Also, the degree of transparency of the lens part 30 and/or the prism part 40 can be used to adjust the characteristics of the sensor arrangement 100. The various parts of the sensor arrangement 100, or some of them, may be made of plastic or resin material, for example. Examples of such plastic materials include thermoplastic polymer materials, such as polyoxymethylene (POM), polysulfone (PSU), polyester (PET), polypropylene (PP) and polyvinyl chloride (PVC). For example, the lens part 30 and the body part 20 could be made of polyoxymethylene, the prism part 40 could be made of polysulfone and the connector part 20 could be made of polyester. Glass, metal and rubber materials and compounds and combinations thereof could also be used, for example. When a separate prism part 40 is used, as in the above embodiments, the lens part 30 is potentially easier and cheaper to produce, because no reflection surface inside it is needed and the material selection can be done more freely. Also, a more reliable reflection can be achieved with a separate prism part as a precise manufacturing of the prism part 40 separate from the lens part 30, or from any other part, is easier since e.g. the materials used can be selected more freely and e.g. a simple moulding tool may be used for the manufacturing.

According to an embodiment, an optical arc flash detection system, such as that shown in Figure 1, comprises at least one sensor arrangement 100 according to any one of the embodiments, or any combination thereof, described herein.

It will be obvious to a person skilled in the art that, as the technology advances, the inventive concept can be implemented in various ways. The invention and its embodiments are not limited to the examples described above but may vary within the scope of the claims.

## Claims

1. A sensor arrangement for an optical arc flash detection system, the arrangement comprising:
a body part (10);
a connector part (20) releasably connected to the body part and adapted to connect to at least two optical fibres (51, 52);
a lens part (30) releasably connected to the body part and adapted to transmit light from outside of the sensor arrangement towards the connector part; and
a prism part (40) located between the lens part and the connector part and adapted to transmit light from the lens part towards the connector part and to reflect light from one optical fibre connected to the connector part to another optical fibre connected to the connector part.

2. A sensor arrangement according to claim 1, wherein the connector part (20) has at least two parallel slots (21) for receiving the at least two optical fibres (51, 52), wherein the ends of the slots facing the prism part (40) are open.

3. A sensor arrangement according to claim 2, wherein the at least two parallel slots (21) are adjacent to each other.

4. A sensor arrangement according to any one of claims 1 to 3, wherein the prism part comprises a reflection prism (40).

5. A sensor arrangement according to claim 4, wherein the reflection prism (40) is of transparent material or at least translucent material.

6. A sensor arrangement according to claim 4 or 5, wherein the reflection prism (40) has a cone shape such that the apex of the cone faces the lens part (30) and the base of the cone faces the connector part (20).

7. A sensor arrangement according to claim 6, wherein the cone is a circular cone.

8. A sensor arrangement according to claim 6, wherein the cone is an elliptic cone.

9. A sensor arrangement according to claim 6, wherein the cone is a pyramid.

10. A sensor arrangement according to any one of claims 6 to 9, wherein the apex angle of the cone is 90°.

11. A sensor arrangement according to any one of claims 1 to 10, wherein the lens part (30) comprises at least one transparent or at least translucent portion allowing light to be transmitted from outside of the sensor arrangement (100) towards the connector part (20).

12. A sensor arrangement according to claim 11, wherein the lens part (30) comprises a recess (31) for receiving the prism part (40) such that at least one side of the prism part is adjacent to said at least one transparent or at least translucent portion.

13. A sensor arrangement according to any one of claims 1 to 12, comprising at least two optical fibres (51, 52) connected to the connector part (20).

14. A sensor arrangement according to claim 13, comprising an optical fibre cable (50) comprising at least two optical fibres (51, 52) connected to the connector part (20).

15. An optical arc flash detection system comprising at least one sensor arrangement (100) according to any one of claims 1 to 14.
